# EUROPEAN PATENT APPLICATION

(11) **EP 4 577 018 A1**
(43) Date of publication of application: **25.06.2025**
(21) Application number: 24218874.6
(22) Date of filing: 10.12.2024
(51) Int. Cl.: H10K 59/12, H10K 59/122

(54) **DISPLAY DEVICE AND MANUFACTURING METHOD OF THE SAME**

(30) Priority: 19.12.2023 KR 20230185706
(71) Applicant: Samsung Display Co., Ltd., Yongin-si, Gyeonggi-do 17113 (KR)
(72) Inventor: LEE, Dongmin, Yongin-si (KR); PARK, Joonyong, Yongin-si (KR); SHIN, Hyuneok, Yongin-si (KR); YANG, Sukyoung, Yongin-si (KR)
(74) Representative: Marks & Clerk LLP

(57) **Abstract**

A display device includes: a pixel electrode on a substrate; a pixel defining layer on the substrate and the pixel electrode and defining a pixel opening exposing at least a portion of the pixel electrode; a first sidewall pattern on the pixel defining layer and including a conductive material; a second sidewall pattern on the first sidewall pattern and having a lower surface defining an undercut structure together with a side surface of the first sidewall pattern in a cross-sectional view; a cladding pattern, which covers at least a portion of the side surface of the first sidewall pattern and includes a conductive material; a light emitting layer on the pixel electrode in the pixel opening; and a common electrode on the light emitting layer and electrically connected to the cladding pattern.

## Description

### BACKGROUND

### 1. Field

The disclosure relates to a display device and a method of manufacturing the display device. More specifically, the disclosure relates to a display device which provides visual information and a method of manufacturing the display device.

### 2. Description of the Related Art

As information technology develops, the importance of a display device as a connection medium between a user and information is being highlighted. For example, the use of display devices, such as the like of a liquid crystal display device ("LCD"), an organic light emitting display device ("OLED"), a plasma display device ("PDP"), and a quantum dot display device, is increasing.

The display device includes a plurality of conductive patterns. For the display device to stably display images, low contact resistance between the conductive patterns is desirable.

### SUMMARY

Embodiments provide a display device with improved reliability.

Embodiments provide a method for manufacturing the display device.

A display device according to an embodiment includes: a pixel electrode on a substrate; a pixel defining layer on the substrate and the pixel electrode and defining a pixel opening exposing at least a portion of the pixel electrode; a first sidewall pattern on the pixel defining layer and including a conductive material; a second sidewall pattern on the first sidewall pattern and having a lower surface defining an undercut structure together with a side surface of the first sidewall pattern in a cross-sectional view; a cladding pattern, which covers at least a portion of the side surface of the first sidewall pattern and includes a conductive material; a light emitting layer on the pixel electrode in the pixel opening; and a common electrode on the light emitting layer and electrically connected to the cladding pattern.

In an embodiment, the cladding pattern may contact the side surface of the first sidewall pattern and the lower surface of the second sidewall pattern.

In an embodiment, the cladding pattern may cover an entirety of a portion, of the lower surface of the second sidewall pattern, that protrudes from an upper surface of the first sidewall pattern.

In an embodiment, the cladding pattern may continuously extend from the side surface of the first sidewall pattern to the lower surface of the second sidewall pattern.

In an embodiment, the cladding pattern may be located within the undercut structure.

In an embodiment, the cladding pattern may overlap the second sidewall pattern in a plan view.

In an embodiment, the cladding pattern and the first sidewall pattern may include different materials from each other.

In an embodiment, the cladding pattern may include molybdenum (Mo).

In an embodiment, the display device may further include an auxiliary electrode on the common electrode and in contact with the cladding pattern.

In an embodiment, a contact area between the cladding pattern and the auxiliary electrode may be larger than a contact area between the cladding pattern and the common electrode.

In an embodiment, the auxiliary electrode may include a conductive oxide.

In an embodiment, the display device may further include a capping pattern on the pixel electrode, at least partially covered by the pixel defining layer, and including a material different from the cladding pattern.

In an embodiment, the capping pattern may include a conductive oxide.

In an embodiment, the display device may further include a dummy cladding pattern which contacts an upper surface of the second sidewall pattern and includes the same material as the cladding pattern.

In an embodiment, the cladding pattern may cover an entirety of the side surface of the first sidewall pattern.

In an embodiment, the cladding pattern may cover a part of the side surface of the first sidewall pattern, not an entirety of the side surface.

In an embodiment, the display device may further include a dummy light emitting layer which is disconnected from the light emitting layer, includes the same material as the light emitting layer, and is disposed on the second sidewall pattern and a dummy common electrode which is disconnected from the common electrode, includes the same material as the common electrode, and is disposed on the dummy light emitting layer.

A method of manufacturing a display device according to an embodiment includes: forming a pixel electrode on a substrate, forming a capping film on the pixel electrode, forming a pixel defining layer on the substrate to cover at least a portion of the pixel electrode and at least a portion of the capping film, forming a first sidewall pattern including a conductive material on the pixel defining layer, and forming a second sidewall pattern including a material different from the first sidewall pattern on the first sidewall pattern, removing a portion of the first sidewall pattern to form an undercut structure defined by a side surface of the first sidewall pattern and a lower surface of the second sidewall pattern in a cross-sectional view, forming a cladding film including a conductive material on the capping film, the pixel defining layer, the first sidewall pattern, and the second sidewall pattern, forming a cladding pattern covering at least a portion of the side surface of the first sidewall pattern by removing a portion of the cladding film through a first etching process, and forming a capping pattern by removing a portion of the capping film through a second etching process.

In an embodiment, an etch rate of the capping film for the first etching process may lower than an etch rate of the cladding film for the first etch process.

In an embodiment, an etch rate of each of the first sidewall pattern, the second sidewall pattern, and the cladding pattern for the second etching process may lower than an etch rate of the capping film for the second etch process.

In an embodiment, the first etching process may be an entire surface etching process.

In an embodiment, the first etching process may be an anisotropic dry etching process.

In an embodiment, in the forming the cladding pattern, the cladding film may be etched such that the cladding pattern is located within the undercut structure.

In an embodiment, in the forming the cladding pattern, the cladding film may be etched such that the cladding pattern overlaps the second sidewall pattern in a plan view.

In an embodiment, the cladding film may be formed to cover an entirety of the first sidewall pattern and the second sidewall pattern.

At least some of the above and other features of the invention are set out in the claims.

The display device according to embodiments may include a sidewall pattern disposed on a pixel defining layer and having an undercut structure. Accordingly, a light emitting layer may be formed independently for each pixel areas through the undercut structure of the sidewall pattern, and leakage current between adjacent pixel areas may be effectively reduced or prevented. Therefore, even in cases where it is difficult to form a light emitting layer using a fine metal mask ("FMM") due to a spacing between the pixel areas and/or size(area) of the pixel areas being too small, a high-resolution display device may be realized.

Additionally, in the display device according to embodiments of the present invention, the sidewall pattern may include a first sidewall pattern and a second sidewall pattern sequentially stacked, and a cladding pattern which covers at least a portion of a side surface of the first sidewall pattern and includes a conductive material may be disposed on the side surface of the first sidewall pattern. Accordingly, the side surface of the first sidewall pattern may be exposed to relatively little or no oxygen in the air. Accordingly, the cladding pattern may effectively reduce or prevent a formation of an oxide film on the side surface of the first sidewall pattern. In addition, even when combined with oxygen in the air, a material (e.g., molybdenum (Mo)) included in the cladding pattern may not form an oxide film, or form only an oxide film that is water-soluble and easily removed. Accordingly, the cladding pattern may have low contact resistance when in contact with the common electrode and/or the auxiliary electrode receiving the power voltage. Accordingly, a reliability of the display device may be effectively improved.

Additionally, in a method of manufacturing the display device according to embodiments of the present invention, the cladding pattern may be formed through an etching process using the undercut structure of the sidewall pattern. For example, the cladding pattern may be formed through an etch-back process using an anisotropic dry etching process. Accordingly, the cladding pattern may be formed without a separate mask or photoresist pattern. Accordingly, the display device may be easily formed, and an efficiency of the manufacturing process of the display device may be effectively improved.

It is to be understood that both the foregoing general description and the following detailed description are explanatory and are intended to provide further explanation of the invention as claimed.

### BRIEF DESCRIPTION OF THE DRAWINGS

Illustrative, non-limiting embodiments will be more clearly understood from the following detailed description taken in conjunction with the accompanying drawings.
FIG. 1 is a plan view illustrating a display device according to an embodiment of the present invention.
FIG. 2 is a cross-sectional view illustrating an example taken along line I-I' of FIG. 1.
FIG. 3 is an enlarged view of area A of FIG. 2.
FIGS. 4 to 14 are views for explaining a method of manufacturing a display device according to an embodiment of the present invention.
FIG. 15 is a cross-sectional view illustrating another example taken along line I-I' of FIG. 1.
FIG. 16 is a cross-sectional view illustrating still another example taken along line I-I' of FIG. 1.

### DETAILED DESCRIPTION

The terminology used herein is for the purpose of describing particular embodiments only and is not intended to be limiting. As used herein, "a", "an," "the," and "at least one" do not denote a limitation of quantity, and are intended to include both the singular and plural, unless the context clearly indicates otherwise. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items. Throughout the disclosure, the expression "at least one of a, b or c" indicates only a, only b, only c, both a and b, both a and c, both b and c, all of a, b, and c, or variations thereof. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that when an element is referred to as being "on" another element or "connected to" another element, it can be directly on or directly connected to the other element or intervening elements may be present therebetween. In contrast, when an element is referred to as being "directly on" another element, there are no intervening elements present.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

Hereinafter, display devices in accordance with embodiments will be described in more detail with reference to the accompanying drawings. The same reference numerals are used for the same components in the drawings, and redundant descriptions of the same components will be omitted.

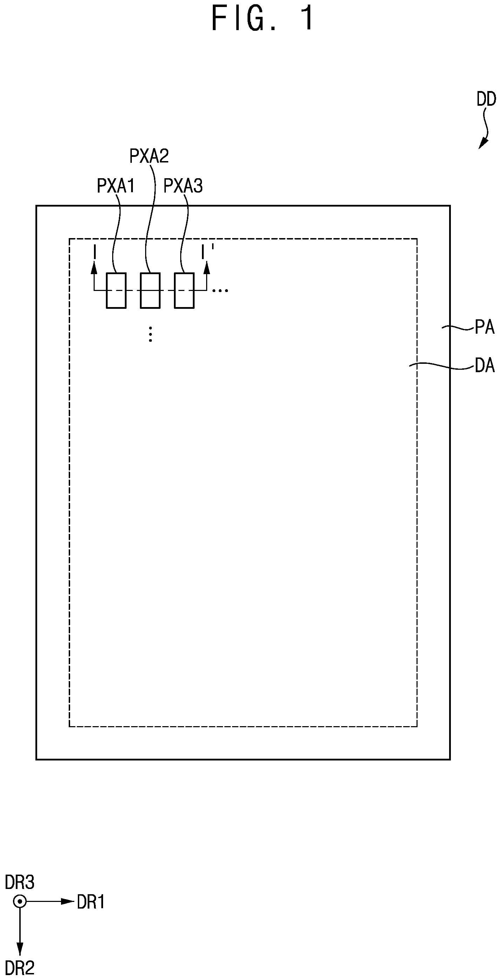

FIG. 1 is a plan view illustrating a display device according to an embodiment of the present invention. As used herein, the "plan view" means a view in a thickness direction (i.e., DR3) of the substrate SUB.

Referring to FIG. 1, a display device DD according to an embodiment of the present invention may include a display area DA and a peripheral area PA. The display area DA may be an area which generates light or displays an image by adjusting a transmittance of light provided from an external light source. The peripheral area PA may be located around the display area DA. For example, the peripheral area PA may surround an entirety of the display area DA. The peripheral area PA may be an area which does not display an image. However, the present invention is not necessarily limited thereto, and the image may be displayed in at least a portion of the peripheral area PA in another embodiment.

The display area DA may include a plurality of pixel areas. The pixel areas may be arranged in a matrix form along a first direction DR1 and a second direction DR2 which intersects the first direction DR1. For example, the pixel areas may include a first pixel area PXA1, a second pixel area PXA2, and a third pixel area PXA3. A third direction DR3 may be a normal direction of a plane defined from the first direction DR1 and the second direction DR2. That is, the third direction DR3 may be perpendicular to the first direction DR1 and the second direction DR2.

Each of the first pixel area PXA1, the second pixel area PXA2, and the third pixel area PXA3 may mean an area where light emitted from the light emitting element is emitted to an outside of the display device DD. For example, a first light may be emitted from the first pixel area PXA1, a second light may be emitted from the second pixel area PXA2, and a third light may be emitted from the third pixel area PXA3. In an embodiment, the first light may be a red light, the second light may be a green light, and the third light may be a blue light. However, the present invention is not necessarily limited thereto. For another example, the first to third pixel areas PXA1, PXA2, and PXA3 may be combined to emit yellow, cyan, and magenta lights.

Each of the first pixel area PXA1, the second pixel area PXA2, and the third pixel area PXA3 may have a triangular planar shape, a square planar shape, a circular planar shape, an oval planar shape, or the like. In an embodiment, each of the first pixel area PXA1, the second pixel area PXA2, and the third pixel area PXA3 may have a rectangular planar shape. However, the present invention is not necessarily limited thereto, and each of the first pixel area PXA1, the second pixel area PXA2, and the third pixel area PXA3 may have a planar shape other than a rectangular planar shape in another embodiment. As used herein, a "planar shape" of an object is a shape of the object in a plan view.

In addition, FIG. 1 illustrates that the first pixel area PXA1, the second pixel area PXA2, and the third pixel area PXA3 all have the same size, but the present invention is not necessarily limited thereto. The first pixel area PXA1, the second pixel area PXA2, and the third pixel area PXA3 may have different sizes from each other in another embodiment.

Drivers which drive pixels in the pixel areas PXA1, PXA2, and PXA3 may be disposed in the peripheral area PA. For example, the drivers may include a gate driver, a data driver, a light emission driver, and/or the like.

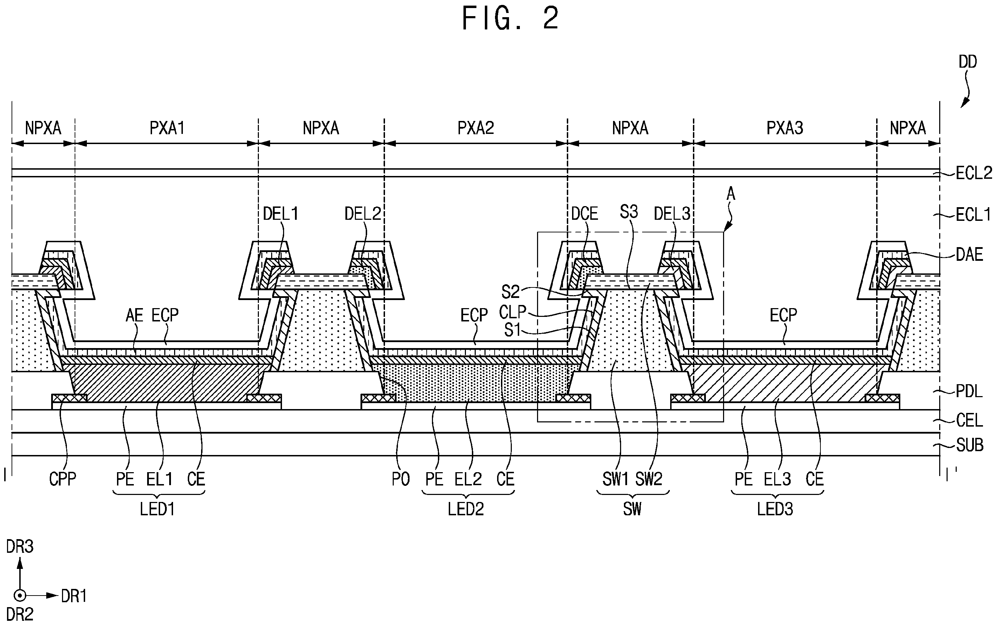

FIG. 2 is a cross-sectional view illustrating an example taken along line I-I' of FIG. 1. As used herein, the "cross-sectional view" means a view cut by a plane including the thickness direction (i.e., DR3) of the substrate SUB.

Referring to FIGS. 1 and 2, the display device DD may include a substrate SUB, a circuit layer CEL, a pixel electrode PE, a capping pattern CPP, a pixel defining layer PDL, a sidewall pattern SW, a cladding pattern CLP, first to third light emitting layers EL1, EL2, and EL3, first to third dummy light emitting layers DEL1, DEL2, and DEL3, a common electrode CE, a dummy common electrode DCE, an auxiliary electrode AE, a dummy auxiliary electrode DAE, an encapsulation pattern ECP, a first encapsulation layer ECL1, and a second encapsulation layer ECL2.

The pixel electrode PE, the first light emitting layer EL1, and the common electrode CE may form a first light emitting element LED 1. The first light emitting element LED1 may correspond to the first pixel area PXA1. The pixel electrode PE, the second light emitting layer EL2, and the common electrode CE may form a second light emitting element LED2. The second light emitting element LED2 may correspond to the second pixel area PXA2. The pixel electrode PE, the third light emitting layer EL3, and the common electrode CE may form a third light emitting element LED3. The third light emitting element LED3 may correspond to the third pixel area PXA3.

The substrate SUB may include transparent or opaque materials. In an embodiment, examples of materials that can be used as the substrate SUB may include glass, quartz, plastic, silicon semiconductor, or the like. These can be used alone or in combination with each other.

The circuit layer CEL may be disposed on the substrate SUB. The circuit layer CEL may include a plurality of transistors. Each of the transistors may include a control electrode, an input electrode, and an output electrode. For example, the circuit layer CEL may include transistors for driving the first to third light emitting elements LED1, LED2, and LED3.

The circuit layer CEL may include a semiconductor pattern, a conductive pattern, and a signal line. An insulating layer, a semiconductor layer, and a conductive layer may be disposed on the substrate SUB by coating, deposition, or like, and the insulating layer, the semiconductor layer, and the conductive layer may be selectively patterned. Accordingly, the circuit layer CEL including the semiconductor pattern, the conductive pattern, and the signal line may be disposed on the substrate SUB.

The pixel electrode PE may be disposed on the circuit layer CEL. The pixel electrode PE may be electrically connected to at least one of the transistors of the circuit layer CEL. The pixel electrode PE may include metal, alloy, metal oxide, transparent conductive material, or the like.

The capping pattern CPP may be disposed on the pixel electrode PE. The capping pattern CPP may expose at least a portion of the pixel electrode PE. In an embodiment, a thickness of the capping pattern CPP in the third direction DR3 may be smaller than a thickness of the pixel electrode PE in the third direction DR3.

The capping pattern CPP may include a conductive material. In an embodiment, for example, the capping pattern CPP may include a conductive oxide. Examples of the conductive oxide that can be used as the capping pattern CPP may include indium tin oxide ("ITO"), indium zinc oxide ("IZO"), indium gallium oxide ("IGO"), indium zinc tin oxide ("IZTO"), indium gallium tin oxide ("IGTO"), indium gallium zinc oxide ("IGZO"), indium gallium zinc tin oxide ("IGZTO"), or the like. These can be used alone or in combination with each other.

An air gap may be defined on the pixel electrode PE by the capping pattern CPP. That is, the air gap may be defined on the pixel electrode PE by a space between the capping patterns CPP. Through this air gap, leakage current between adjacent pixel areas may be further reduced.

In FIG. 2, an end of the capping pattern CPP is illustrated to protrude toward a pixel opening PO over an end of the pixel defining layer PDL, but the present invention is not necessarily limited thereto. For another example, the end of the capping pattern CPP may be recessed further from the pixel opening PO rather than the end of the pixel defining layer PDL, thereby defining an undercut structure with the pixel defining layer PDL. Through this, leakage current between adjacent pixel areas may be further reduced.

The pixel defining layer PDL may be disposed on the circuit layer CEL, the pixel electrode PE, and the capping pattern CPP.

The pixel defining layer PDL covers at least a portion of the pixel electrode PE. Additionally, the pixel defining layer PDL may cover at least a portion of the capping pattern CPP. The pixel defining layer PDL may define the pixel opening PO which exposes at least a portion of the pixel electrode PE. The pixel defining layer PDL may correspond to a non-pixel area NPXA. That is, the first to third pixel areas PXA1, PXA2, and PXA3 may be defined by the pixel opening PO of the pixel defining layer PDL.

In an embodiment, the pixel defining layer PDL may include an inorganic material. Examples of the inorganic material that can be used as the pixel defining layer PDL may include silicon nitride (SiNx), silicon oxide (SiOx), silicon oxynitride (SixNyOz), magnesium fluoride (MgFx), or the like. These can be used alone or in combination with each other. The pixel defining layer PDL may have a single-layer structure or a multi-layer structure including a plurality of layers.

The sidewall pattern SW may be disposed on the pixel defining layer PDL. In an embodiment, for example, the sidewall pattern SW may be disposed between adjacent pixel areas. The sidewall pattern SW may have a multi-layer structure. In an embodiment, for example, the sidewall pattern SW may include a first sidewall pattern SW1 and a second sidewall pattern SW2 which are sequentially stacked.

The first sidewall pattern SW1 is disposed on the pixel defining layer PDL. The first sidewall pattern SW1 includes a conductive material. Examples of the conductive material that can be used as the first sidewall pattern SW1 may include aluminium (Al), chromium (Cr), titanium (Ti), gold (Au), silver (Ag), indium tin oxide (ITO), or the like. These can be used alone or in combination with each other. Preferably, the first sidewall pattern SW1 may include aluminium (Al).

The second sidewall pattern SW2 is disposed on the first sidewall pattern SW1. The second sidewall pattern SW2 may protect the first sidewall pattern SW1 from corrosion, oxidation, or the like. In an embodiment, the second sidewall pattern SW2 may include a different material from the first sidewall pattern SW1. In an embodiment, for example, the first sidewall pattern SW1 may include a first conductive material, and the second sidewall pattern SW2 may include a second conductive material different from the first conductive material. In an embodiment, for example, the first conductive material may be aluminium (Al), and the second conductive material may be titanium (Ti). However, a material that can be used as the second sidewall pattern SW2 is not necessarily limited as long as it is different from the first sidewall pattern SW1. For another example, the second sidewall pattern SW2 may include an inorganic insulating material.

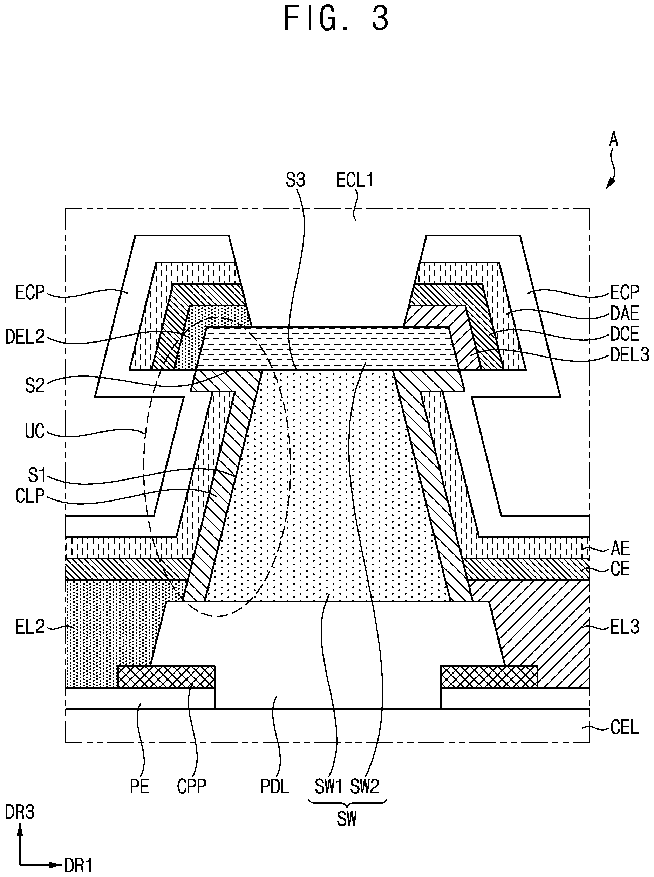

FIG. 3 is an enlarged view of area A of FIG. 2.

Hereinafter, with further reference to FIG. 3, a structure of the sidewall pattern SW and a structure around the sidewall pattern SW will be described in more detail.

Referring to FIGS. 2 and 3, the sidewall pattern SW may have an undercut structure UC. In an embodiment, for example, the first sidewall pattern SW1 and the second sidewall pattern SW2 may define the undercut structure UC. Specifically, a side surface S1 of the first sidewall pattern SW1 and a lower surface S2 of the second sidewall pattern SW2 define the undercut structure UC.

A width of the lower surface S2 of the second sidewall pattern SW2 in the first direction DR1 may be greater than a width of an upper surface S3 of the first sidewall pattern SW1 in the first direction DR1. Accordingly, the second sidewall pattern SW2 may protrude in the first direction DR1 or in a direction opposite to the first direction DR1 from a point where the side surface S1 of the first sidewall pattern SW1 and the upper surface S3 of the first sidewall pattern SW1 meet. That is, the second sidewall pattern SW2 may define a tip structure. In other words, the lower surface S2 of the second sidewall pattern SW2 may have a portion protruding from the upper surface S3 of the first sidewall pattern SW1 in the first direction DR1 or in the direction opposite to the first direction DR1. Accordingly, the undercut structure UC may be defined by the side surface S1 of the first sidewall pattern SW1 and the lower surface S2 of the second sidewall pattern SW2.

The cladding pattern CLP is disposed on the side surface S1 of the first sidewall pattern SW1. In an embodiment, for example, the cladding pattern CLP may contact the side surface S1 of the first sidewall pattern SW1. The cladding pattern CLP covers at least a portion of the side surface S1 of the first sidewall pattern SW1. In an embodiment, for example, the cladding pattern CLP may cover an entirety of the side surface S1 of the first sidewall pattern SW1. However, the present invention is not necessarily limited thereto. The cladding pattern CLP may have a single-layer structure or a multi-layer structure including a plurality of layers.

The cladding pattern CLP may be located within the undercut structure UC of the sidewall pattern SW. In an embodiment, for example, the cladding pattern CLP may overlap the second sidewall pattern SW2 in a plan view.

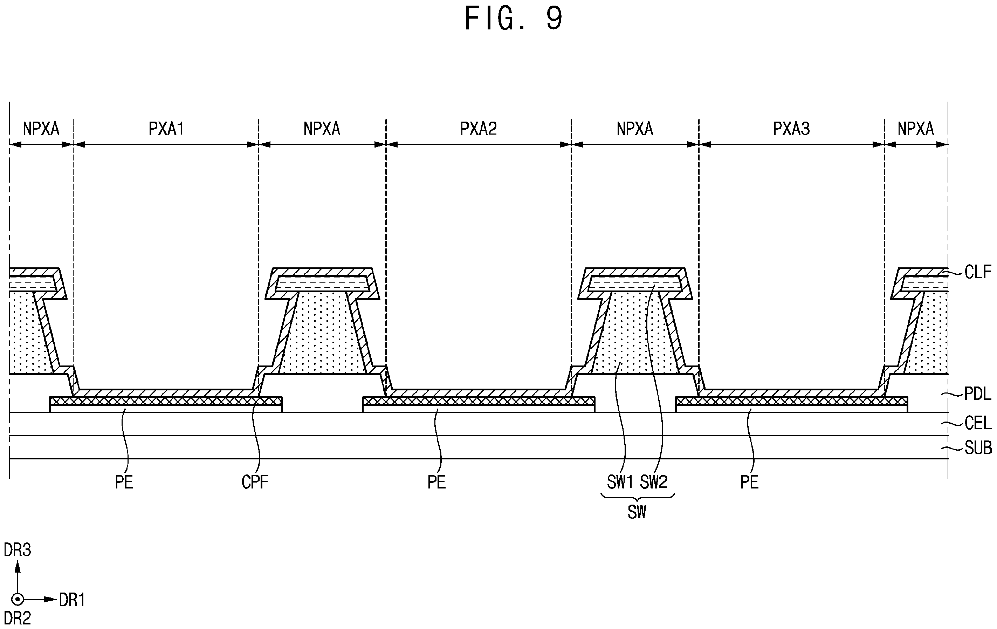

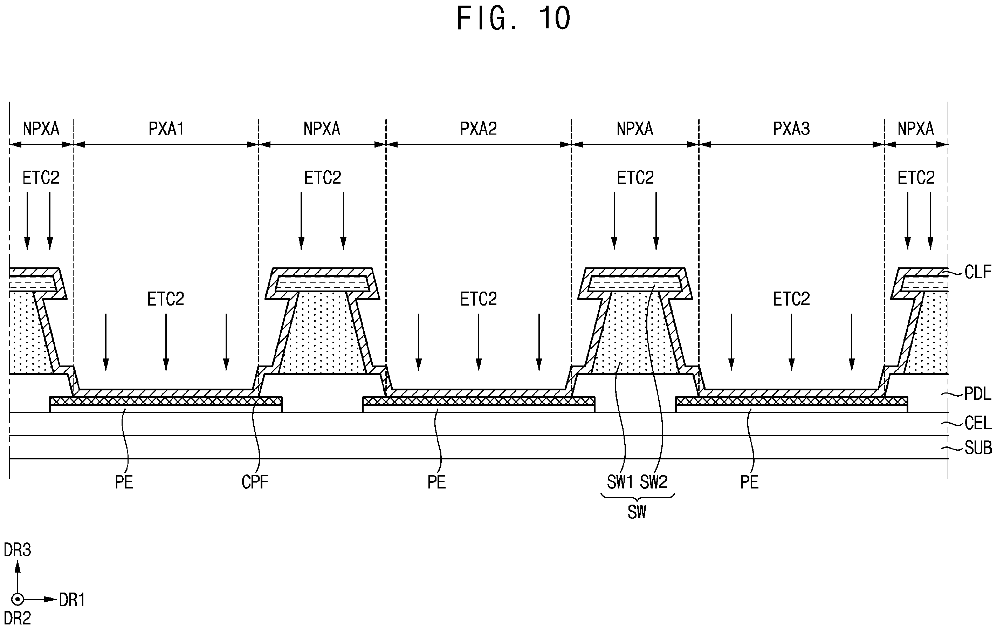

In an embodiment, when forming a cladding film (CLF, see FIG. 9) which covers an entirety of the sidewall pattern SW and performing an entire surface etching process on the cladding film, the cladding pattern CLP located within the undercut structure UC may be formed. In other words, when performing the entire surface etching process on the cladding film, a portion of the cladding film obscured by the tip structure of the second sidewall pattern SW2 may not be etched and may remain as the cladding pattern CLP. Accordingly, the cladding pattern CLP may be located within the undercut structure UC of the sidewall pattern SW. This will be described in more detail later with reference to FIGS. 9 and 10.

The cladding pattern CLP may contact the lower surface S2 of the second sidewall pattern SW2. In an embodiment, for example, the cladding pattern CLP may cover at least a portion of the lower surface S2 of the second sidewall pattern SW2. Specifically, the cladding pattern CLP may cover the portion of the lower surface S2 of the second sidewall pattern SW2 protruding from the upper surface S3 of the first sidewall pattern SW1 in the first direction DR1 or in the direction opposite to the first direction DR1. In an embodiment, for example, the cladding pattern CLP may cover an entirety of the portion of the lower surface S2 of the second sidewall pattern SW2 protruding from the upper surface S3 of the first sidewall pattern SW1 in the first direction DR1 or in the direction opposite to the first direction DR1.

As described above, the cladding pattern CLP may be a portion of the cladding film which is not etched by the tip structure of the second sidewall pattern SW2 when the entire surface etching process is performed on the cladding film. Accordingly, the cladding pattern CLP may cover the portion of the lower surface S2 of the second sidewall pattern SW2 protruding from the upper surface S3 of the first sidewall pattern SW1 in the first direction DR1 or in the direction opposite to the first direction DR1.

In an embodiment, the cladding pattern CLP may continuously extend from the side surface S1 of the first sidewall pattern SW1 to the lower surface S2 of the second sidewall pattern SW2. In an embodiment, for example, when the cladding pattern CLP covers an entirety of the side surface S1 of the first sidewall pattern SW1, the cladding pattern CLP may continuously extend from an upper surface of the pixel defining layer PDL to the lower surface S2 of the second sidewall pattern SW2 along the side surface S1 of the first sidewall pattern SW1.

The cladding pattern CLP includes a conductive material and may be electrically connected to the common electrode CE. That is, even when the cladding pattern CLP covers at least a portion of the side surface S1 of the first sidewall pattern SW1, the common electrode CE may be electrically connected to the first sidewall pattern SW1 through the cladding pattern CLP. Accordingly, a power voltage applied to the first sidewall pattern SW1 may be transmitted to the common electrode CE.

In an embodiment, the cladding pattern CLP may include molybdenum (Mo). In an embodiment, for example, the cladding pattern CLP may be a single-layer structure including molybdenum Mo. For another example, the cladding pattern CLP may have a multi-layer structure including at least one layer including molybdenum (Mo). In this case, the layer including molybdenum (Mo) may be disposed in the outermost layer among several layers of the cladding pattern CLP.

The cladding pattern CLP may include a different material from the first sidewall pattern SW1. In an embodiment, for example, the first sidewall pattern SW1 may include the first conductive material, and the cladding pattern CLP may include a third conductive material different from the first conductive material. In an embodiment, for example, the first conductive material may be aluminium (Al), and the third conductive material may be molybdenum (Mo).

The cladding pattern CLP may include a different material from the capping pattern CPP. In an embodiment, for example, the capping pattern CPP may include a conductive oxide, and the cladding pattern CLP may include the third conductive material that is different from a conductive oxide. In an embodiment, for example, the conductive oxide of the capping pattern CPP may include indium tin oxide (ITO), indium zinc oxide (IZO), indium gallium oxide (IGO), indium zinc tin oxide (IZTO), indium gallium tin oxide (IGTO), indium gallium zinc oxide (IGZO), indium gallium zinc tin oxide (IGZTO), or the like, and the third conductive material may be molybdenum (Mo).

The cladding pattern CLP may effectively reduce or prevent oxidation of the side surface S1 of the first sidewall pattern SW1. For example, when the side surface S1 of the first sidewall pattern SW1 is oxidized to form an oxide film, the oxide film may have high contact resistance when in contact with the common electrode CE and/or the auxiliary electrode AE. High contact resistance may cause heating issues, reduced luminance, and poor signal transmission that lead to reduced reliability of the display device DD.

According to embodiments, the cladding pattern CLP covers at least a portion of the side surface S1 of the first sidewall pattern SW1. Accordingly, the side surface S1 of the first sidewall pattern SW1 may be less exposed to oxygen in the air or may not be exposed to oxygen at all. Accordingly, a formation of the oxide film on the side surface S1 of the first sidewall pattern SW1 may be reduced or prevented. In addition, even when combined with oxygen in the air, the conductive material (e.g., molybdenum (Mo)) included in the cladding pattern CLP may not form an oxide film, or form only an oxide film that is water-soluble and easily removed. Accordingly, the cladding pattern CLP may have low contact resistance when in contact with the common electrode CE and/or the auxiliary electrode AE. Accordingly, the reliability of the display device DD may be effectively improved.

The first to third light emitting layers EL1, EL2, and EL3 may be disposed on the pixel electrode PE. In an embodiment, for example, the first light emitting layer EL1 may be disposed on the pixel electrode PE in the pixel opening PO defining the first pixel area PXA1, the second light emitting layer EL2 may be disposed on the pixel electrode PE in the pixel opening PO defining the second pixel area PXA2, and the third light emitting layer EL3 may be disposed on the pixel electrode PE in the pixel opening PO defining the third pixel area PXA3.

The first to third light emitting layers EL1, EL2, and EL3 may include a light emitting material. In an embodiment, for example, the first to third light emitting layers EL1, EL2, and EL3 may include an organic light emitting material. However, the present invention is not necessarily limited thereto.

Each of the first to third light emitting layers EL1, EL2, and EL3 may include a light emitting material layer and a functional layer. The functional layer may include a hole transport layer, a hole injection layer, an electron transport layer, an electron injection layer, or the like.

The light emitting material layer of the first light emitting layer EL1 may include a material that emits the first light, the light emitting material layer of the second light emitting layer EL2 may include a material that emits the second light, and the light emitting material layer of the third light emitting layer EL3 may include a material that emits the third light. In an embodiment, the first light may be a red light, the second light may be a green light, and the third light may be a blue light.

However, the present invention is not necessarily limited thereto, and each of the first to third light emitting layers EL1, EL2, and EL3 may include two or more light emitting material layers, and the light emitting material layers may be combined to emit white light in another embodiment.

The first to third dummy light emitting layers DEL1, DEL2, and DEL3 may be disposed on the second sidewall pattern SW2. In an embodiment, for example, the first to third dummy light emitting layers DEL1, DEL2, and DEL3 may contact the second sidewall pattern SW2.

The first to third dummy light emitting layers DEL1, DEL2, and DEL3 may be disconnected from the first to third light emitting layers EL1, EL2, and EL3. In an embodiment, for example, when performing a deposition process to form the first to third light emitting layers EL1, EL2, and EL3 and the first to third dummy light emitting layers DEL1, DEL2, and DEL3, the first to third light emitting layers EL1, EL2, and EL3 and the first to third dummy light emitting layers DEL1, DEL2, and DEL3 may be disconnected from each other by the undercut structure UC of the sidewall pattern SW. That is, the first to third light emitting layers EL1, EL2, and EL3 and the first to third dummy light emitting layers DEL1, DEL2, and DEL3 may be disconnected from each other by the tip structure of the second sidewall pattern SW2.

Specifically, the first dummy light emitting layer DEL1 may be disposed on the second sidewall pattern SW2 adjacent to the first pixel area PXA1. The first light emitting layer EL1 and the first dummy light emitting layer DEL1 may include the same material and may be disconnected from each other. In an embodiment, for example, when performing a deposition process to form the first light emitting layer EL1 on the pixel electrode PE corresponding to the first pixel area PXA1, the first dummy light emitting layer DEL1 which is disconnected from the first light emitting layer EL1 may be formed together with the first light emitting layer EL1 by the undercut structure UC of the sidewall pattern SW.

Additionally, the second dummy light emitting layer DEL2 may be disposed on the second sidewall pattern SW2 adjacent to the second pixel area PXA2. The second light emitting layer EL2 and the second dummy light emitting layer DEL2 may include the same material and may be disconnected from each other. In an embodiment, for example, when performing a deposition process to form the second light emitting layer EL2 on the pixel electrode PE corresponding to the second pixel area PXA2, the second dummy light emitting layer DEL2 which is disconnected from the second light emitting layer EL2 may be formed together with the second light emitting layer EL2 by the undercut structure UC of the sidewall pattern SW.

Additionally, the third dummy light emitting layer DEL3 may be disposed on the second sidewall pattern SW2 adjacent to the third pixel area PXA3. The third light emitting layer EL3 and the third dummy light emitting layer DEL3 may include the same material and may be disconnected from each other. In an embodiment, for example, when performing a deposition process to form the third light emitting layer EL3 on the pixel electrode PE corresponding to the third pixel area PXA3, the third dummy light emitting layer DEL3 which is disconnected from the third light emitting layer EL3 may be formed together with the third light emitting layer EL3 by the undercut structure UC of the sidewall pattern SW.

The common electrode CE may be disposed on the first to third light emitting layers EL1, EL2, and EL3. The common electrode CE may be electrically connected to the first sidewall pattern SW1. In an embodiment, for example, the common electrode CE may be in contact with the cladding pattern CLP, and accordingly, the common electrode CE may be electrically connected to the first sidewall pattern SW1 through the cladding pattern CLP. However, the present invention is not necessarily limited thereto, and when the cladding pattern CLP covers just a part of the side surface S1 of the first sidewall pattern SW1, the common electrode CE may directly contact the first sidewall pattern SW1.

As the common electrode CE is electrically connected to the first sidewall pattern SW1, when the power voltage is applied to the first sidewall pattern SW1, the power voltage may be transmitted to the common electrode CE. The common electrode CE may include metal, alloy, metal oxide, transparent conductive material, or the like.

The dummy common electrode DCE may be disposed on the first to third dummy light emitting layers DEL1, DEL2, and DEL3. In an embodiment, for example, the dummy common electrode DCE may contact the first to third dummy light emitting layers DEL1, DEL2, and DEL3 on the second sidewall pattern SW2.

The dummy common electrode DCE may be disconnected from the common electrode CE. In an embodiment, for example, when performing a deposition process to form the common electrode CE and the dummy common electrode DCE, the common electrode CE and the dummy common electrode DCE may be disconnected from each other by the undercut structure UC of the sidewall pattern SW. The common electrode CE and the dummy common electrode DCE may include the same material.

The auxiliary electrode AE may be disposed on the common electrode CE. The auxiliary electrode AE may contact the cladding pattern CLP. Accordingly, the auxiliary electrode AE may be electrically connected to the cladding pattern CLP. Accordingly, the auxiliary electrode AE may be electrically connected to the first sidewall pattern SW1 through the cladding pattern CLP. As the auxiliary electrode AE may be electrically connected to the first sidewall pattern SW1, when the power voltage is applied to the first sidewall pattern SW1, the power voltage may be transmitted to the auxiliary electrode AE.

The auxiliary electrode AE may be in contact with the common electrode CE. That is, the auxiliary electrode AE may be electrically connected to the common electrode CE. Accordingly, the auxiliary electrode AE may transmit the power voltage to the common electrode CE. In conclusion, the auxiliary electrode AE may assist the common electrode CE and receive the power voltage from the first sidewall pattern SW1 together with the common electrode CE.

In an embodiment, a contact area between the cladding pattern CLP and the auxiliary electrode AE may be larger than a contact area between the cladding pattern CLP and the common electrode CE. Accordingly, a contact resistance between the cladding pattern CLP and the auxiliary electrode AE may be lower than a contact resistance between the cladding pattern CLP and the common electrode CE. Therefore, when the auxiliary electrode AE receives the power voltage from the first sidewall pattern SW1 together with the common electrode CE, a contact resistance may be lower than when the power voltage is transmitted from the first sidewall pattern SW1 only through the common electrode CE.

In an embodiment, the auxiliary electrode AE may include a conductive oxide. In an embodiment, for example, the auxiliary electrode AE may include transparent conductive oxide. Examples of the transparent conductive oxide that can be used as the auxiliary electrode AE may include indium zinc oxide (IZO), indium tin oxide (ITO), or the like. These can be used alone or in combination with each other.

The dummy auxiliary electrode DAE may be disposed on the dummy common electrode DCE. In an embodiment, for example, the dummy auxiliary electrode DAE may contact the dummy common electrode DCE on the second sidewall pattern SW2.

The dummy auxiliary electrode DAE may be disconnected from the auxiliary electrode AE. In an embodiment, for example, when performing a deposition process to form the auxiliary electrode AE and the dummy auxiliary electrode DAE, the auxiliary electrode AE and the dummy auxiliary electrode DAE may be disconnected from each other by the undercut structure UC of the sidewall pattern SW. The auxiliary electrode AE and the dummy auxiliary electrode DAE may include the same material.

The encapsulation pattern ECP may be disposed on the auxiliary electrode AE and the dummy auxiliary electrode DAE. The encapsulation pattern ECP may be disposed to correspond to the first to third light emitting elements LED1, LED2, and LED3, respectively. In an embodiment, the encapsulation pattern ECP may include an inorganic material.

In an embodiment, the encapsulation pattern ECP may have a structure which is disconnected on the sidewall pattern SW. That is, the encapsulation pattern ECP covering one light emitting element may not be connected to the encapsulation pattern ECP covering another adjacent light emitting element. However, the present invention is not necessarily limited thereto, and the encapsulation pattern ECP may also continuously extend on the first to third light emitting elements LED1, LED2, and LED3 in another embodiment.

The first encapsulation layer ECL1 may be disposed on the sidewall pattern SW and the encapsulation pattern ECP. In an embodiment, the first encapsulation layer ECL1 may include an organic material. The second encapsulation layer ECL2 may be disposed on the first encapsulation layer ECL1. In an embodiment, the second encapsulation layer ECL2 may include an inorganic material.

The encapsulation pattern ECP, the first encapsulation layer ECL1, and the second encapsulation layer ECL2 may form an encapsulation member. The encapsulation member may protect the first to third light emitting elements LED1, LED2, and LED3 and the auxiliary electrode AE from external impurities. Meanwhile, a structure of the encapsulation member is not necessarily limited thereto, and a stacked structure of the encapsulation member may be changed in various ways.

Although not illustrated, the display device DD may further include various functional members disposed on the second encapsulation layer ECL2. Examples of the functional members may include a touch member which detects a touch from the outside, an optical member which adjusts the characteristics of light emitted from light emitting elements, and a cover member which protects components from external shock. The touch member may include at least one touch electrode. The optical member may include a color filter, a light blocking member, a color conversion member, a polarizing layer, or the like. The cover member may include a cover window, a protective film, a hard coating layer, an anti-fingerprint layer, or the like.

The display device DD according to embodiments of the present invention includes the sidewall pattern SW disposed on the pixel defining layer PDL and having the undercut structure UC. Accordingly, the light emitting layer may be formed independently for each pixel areas through the undercut structure UC of the sidewall pattern SW, and leakage current between adjacent pixel areas may be effectively reduced or prevented. Therefore, even in cases where it is difficult to form a light emitting layer using a fine metal mask (FMM) due to a spacing between pixel areas and/or size (area) of the pixel areas being too small, a high-resolution display device DD may be realized.

Additionally, in the display device DD according to embodiments of the present invention, the sidewall pattern SW includes the first sidewall pattern SW1 and the second sidewall pattern SW2 sequentially stacked, and the cladding pattern CLP which covers at least a portion of the side surface S1 of the first sidewall pattern SW1 and includes a conductive material is disposed on the side surface S1 of the first sidewall pattern SW1. Accordingly, the side surface S1 of the first sidewall pattern SW1 may be exposed to relatively little or no oxygen in the air. Accordingly, the cladding pattern CLP may effectively reduce or prevent a formation of an oxide film on the side surface S1 of the first sidewall pattern SW1. In addition, even when combined with oxygen in the air, the material (e.g., molybdenum (Mo)) included in the cladding pattern CLP may not form an oxide film, or form only an oxide film that is water-soluble and easily removed. Accordingly, the cladding pattern CLP may have low contact resistance when in contact with the common electrode CE and/or the auxiliary electrode AE receiving the power voltage. Accordingly, the reliability of the display device DD may be effectively improved.

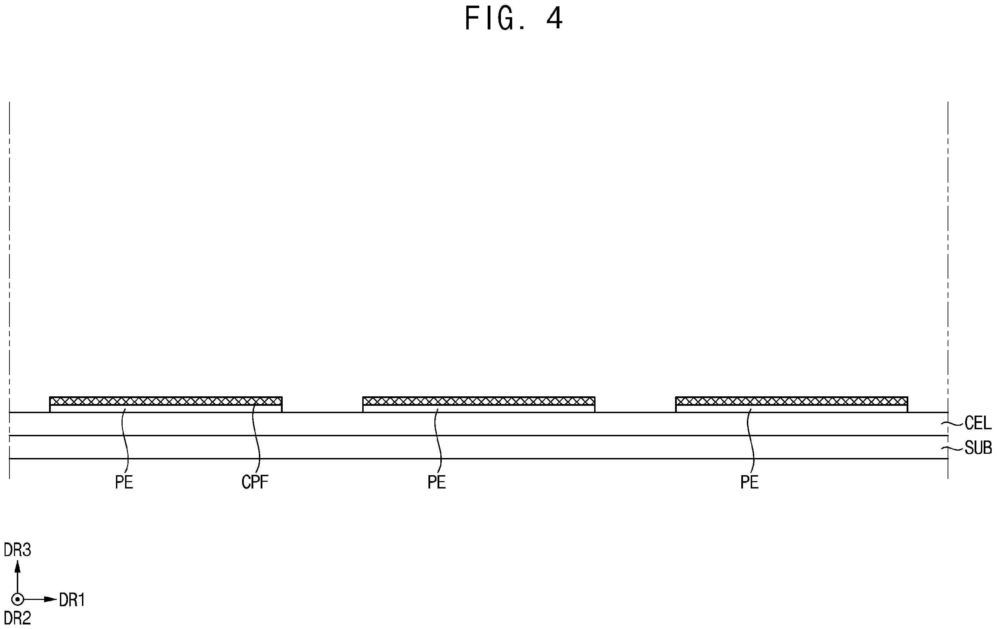

FIGS. 4 to 14 are views for explaining a method of manufacturing a display device according to an embodiment of the present invention.

A manufacturing method of the display device DD described with reference to FIGS. 4 to 14 may be a manufacturing method of the display device DD described with reference to FIGS. 1 to 3. Hereinafter, descriptions that overlap with those of the display device DD described above with reference to FIGS. 1 to 3 will be omitted or simplified.

Referring to FIG. 4, the pixel electrode PE and the capping film CPF may be formed on the substrate SUB. Specifically, the circuit layer CEL may be formed on the substrate SUB, and the pixel electrode PE and the capping film CPF may be formed on the circuit layer CEL.

The substrate SUB may be formed of various materials. In an embodiment, for example, the substrate SUB may be formed of glass, quartz, plastic, silicon semiconductor, or the like.

As described above, the circuit layer CEL may be formed by forming the insulating layer, the semiconductor layer, and the conductive layer on the substrate SUB by coating, deposition, or the like, and selectively patterning the insulating layer, the semiconductor layer, and the conductive layer.

The pixel electrode PE may be formed on the circuit layer CEL. The pixel electrode PE may be formed of metal, alloy, metal oxide, transparent conductive material, or the like. The pixel electrode PE may be formed to be electrically connected to at least one of the transistors of the circuit layer CEL.

The capping film CPF may be formed on the pixel electrode PE. In an embodiment, for example, the capping film CPF may be formed to cover an entirety of an upper surface of the pixel electrode PE. The capping film CPF may be formed of a conductive oxide. Examples of the conductive oxide that can be used as the capping film CPF include indium tin oxide (ITO), indium zinc oxide (IZO), indium gallium oxide (IGO), indium zinc tin oxide (IZTO), indium gallium tin oxide (IGTO), indium gallium zinc oxide (IGZO), indium gallium zinc tin oxide (IGZTO), or the like. These can be used alone or in combination with each other. The capping film CPF may protect the pixel electrode PE during an etching process of the cladding film (CLF, see FIG. 9), which will be described later.

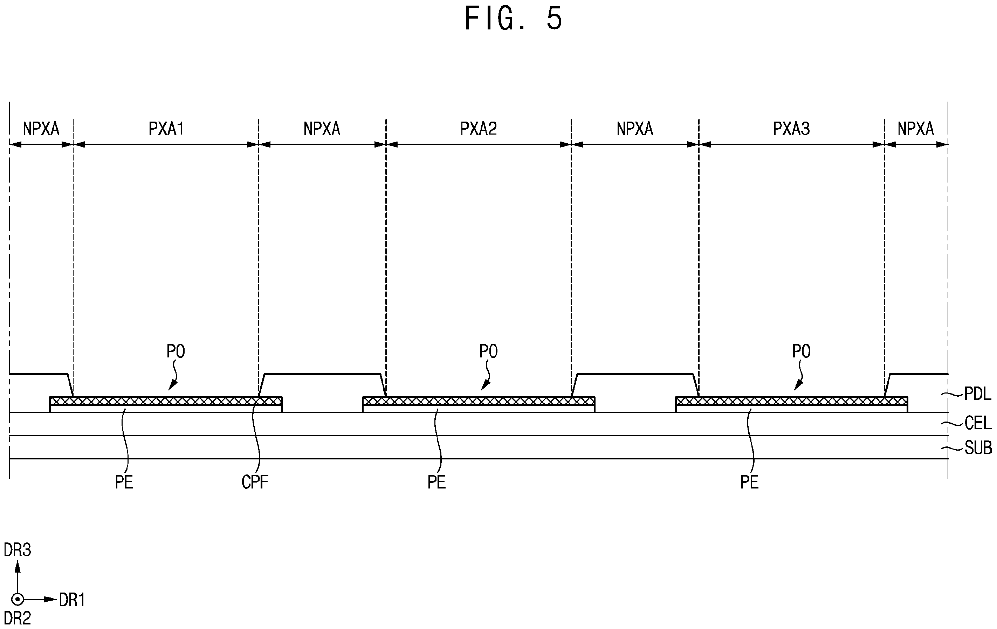

Referring to FIG. 5, the pixel defining layer PDL may be formed on the circuit layer CEL. The pixel defining layer PDL may be formed to cover at least a portion of the pixel electrode PE and at least a portion of the capping film CPF. The pixel defining layer PDL may be formed to define the pixel opening PO. As described above, the first to third pixel areas PXA1, PXA2, and PXA3 may be defined by the pixel opening PO. That is, the pixel defining layer PDL may be formed to correspond to the non-pixel area NPXA.

In an embodiment, the pixel defining layer PDL may be formed of an inorganic material. Examples of the inorganic material that can be used as the pixel defining layer PDL may include silicon nitride (SiNx), silicon oxide (SiOx), silicon oxynitride (SixNyOz), magnesium fluoride (MgFx), or the like. These can be used alone or in combination with each other. The pixel defining layer PDL may be formed as a single-layer structure or a multi-layer structure including a plurality of layers.

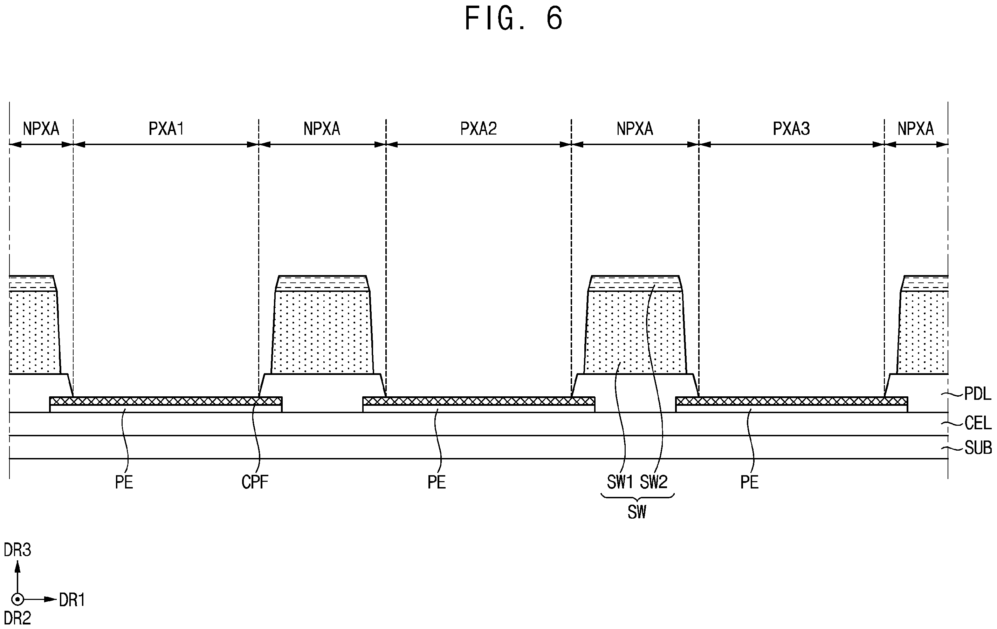

Referring to FIG. 6, the sidewall pattern SW may be formed on the pixel defining layer PDL. The sidewall pattern SW may be formed in a structure in which the first sidewall pattern SW1 and the second sidewall pattern SW2 are sequentially stacked. Each of the first sidewall pattern SW1 and the second sidewall pattern SW2 may be formed through a patterning process. In an embodiment, for example, a patterning process to form the first sidewall pattern SW1 and a patterning process to form the second sidewall pattern SW2 may be performed sequentially. For another example, the first sidewall pattern SW1 and the second sidewall pattern SW2 may be formed simultaneously through a single patterning process.

The first sidewall pattern SW1 may be formed of a conductive material. Examples of the conductive material that can be used as the first sidewall pattern SW1 may include aluminium (Al), chromium (Cr), titanium (Ti), gold (Au), silver (Ag), indium tin oxide (ITO), or the like. These can be used alone or in combination with each other. Preferably, the first sidewall pattern SW1 may be formed of aluminium (Al).

In an embodiment, the second sidewall pattern SW2 may be formed of a different material from the first sidewall pattern SW1. In an embodiment, for example, the first sidewall pattern SW1 may be formed of aluminium (Al), and the second sidewall pattern SW2 may be formed of titanium (Ti). However, the present invention is not necessarily limited thereto.

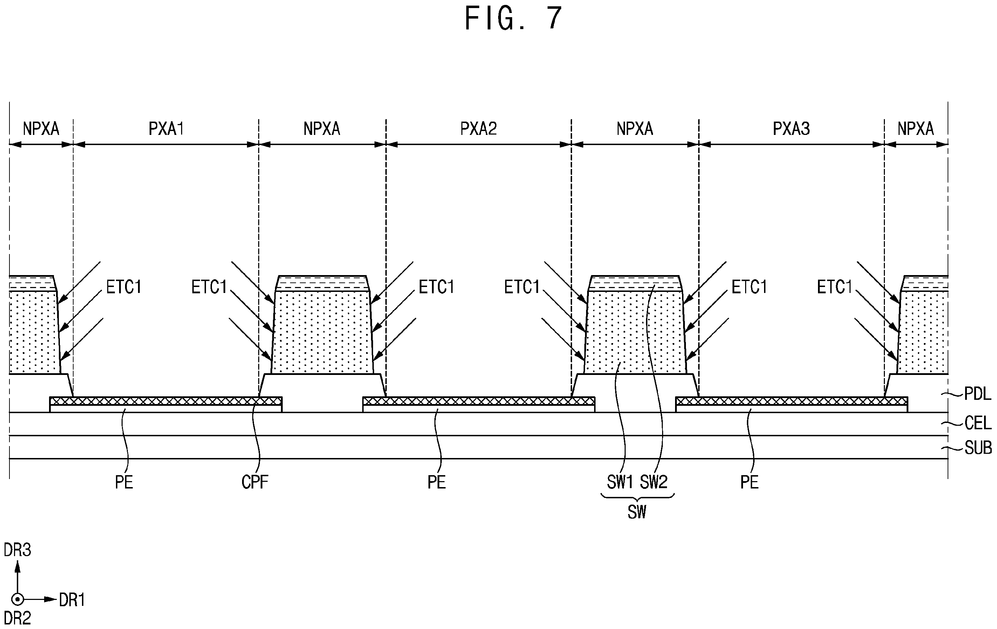

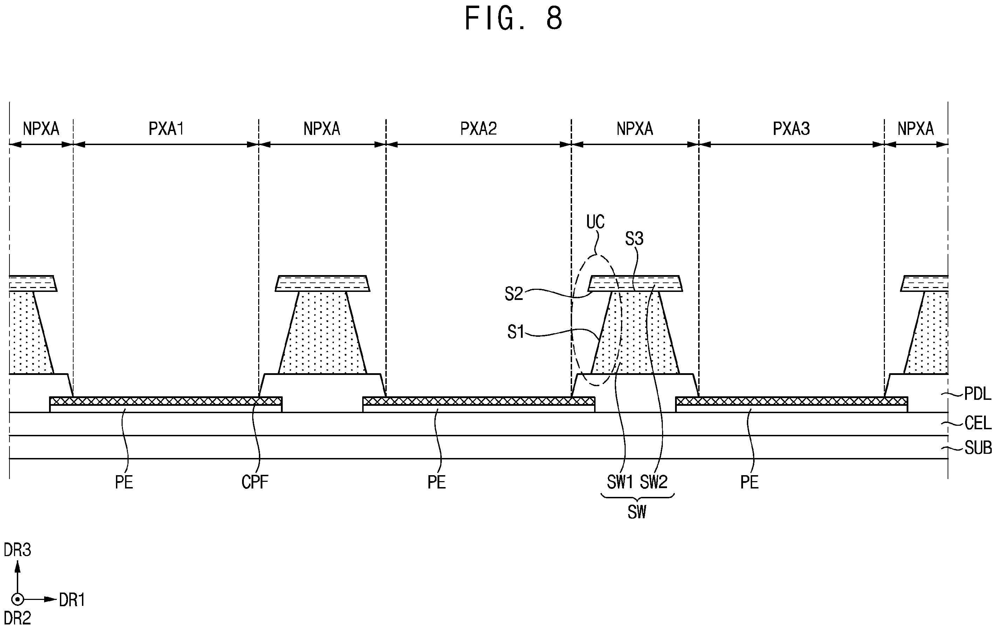

Referring to FIGS. 7 and 8, the undercut structure UC may be formed by removing a portion of the first sidewall pattern SW1. In an embodiment, for example, the portion of the first sidewall pattern SW1 may be removed through a first etching process ETC1. In an embodiment, the first etching process ETC1 may be a dry etching process or a wet etching process.

An etch rate of the second sidewall pattern SW2 for the first etching process ETC1 may be lower than an etch rate of the first sidewall pattern SW1 for the first etching process ETC1. In an embodiment, for example, the second sidewall pattern SW2 may not be etched by the first etching process ETC1.

Accordingly, as illustrated in FIG. 8, the side surface S1 of the first sidewall pattern SW1 located inside the sidewall pattern SW rather than an end of the second sidewall pattern SW2 may be defined. That is, the width of the lower surface S2 of the second sidewall pattern SW2 in the first direction DR1 may be greater than the width of the upper surface S3 of the first sidewall pattern SW1 in the first direction DR1. Accordingly, the second sidewall pattern SW2 may protrude in the first direction DR1 or in a direction opposite to the first direction DR1 from the point where the side surface S1 of the first sidewall pattern SW1 and the upper surface S3 of the first sidewall pattern SW1 meet. That is, the second sidewall pattern SW2 may define the tip structure. In other words, the lower surface S2 of the second sidewall pattern SW2 may have a portion protruding from the upper surface S3 of the first sidewall pattern SW1 in the first direction DR1 or in the direction opposite to the first direction DR1. Accordingly, the undercut structure UC may be defined by the side surface S1 of the first sidewall pattern SW1 and the lower surface S2 of the second sidewall pattern SW2.

Referring to FIG. 9, a cladding film CLF may be formed on the capping film CPF, the pixel defining layer PDL, and the sidewall pattern SW. In an embodiment, for example, the cladding film CLF may be formed on an entire surface of the substrate SUB (or the circuit layer CEL). In an embodiment, for example, the cladding film CLF may be formed to cover an entirety of the capping film CPF, the pixel defining layer PDL, and the sidewall pattern SW.

The cladding film CLF may be formed of a conductive material. In an embodiment, for example, the cladding film CLF may be formed of molybdenum Mo.

The cladding film CLF may be formed of a different material from the first sidewall pattern SW1. In an embodiment, for example, the first sidewall pattern SW1 may be formed of aluminium (Al), and the second sidewall pattern SW2 may be formed of titanium (Ti). Additionally, the cladding film CLF may be formed of a different material from the capping film CPF. In an embodiment, for example, the capping film CPF may be formed of a conductive oxide, and the cladding film CLF may be formed of molybdenum (Mo).

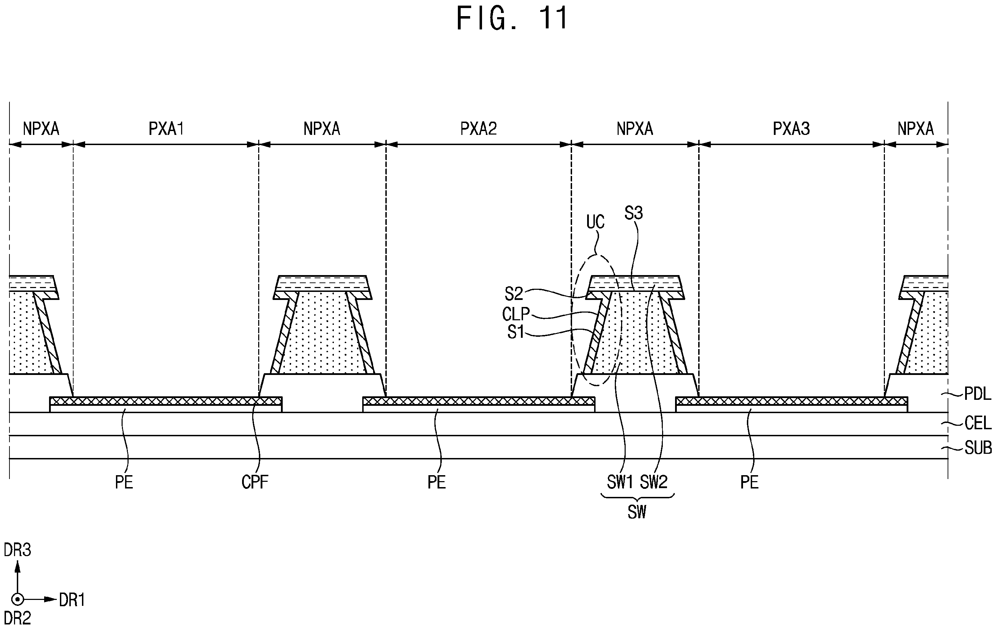

Referring to FIGS. 10 and 11, the cladding pattern CLP may be formed by removing a portion of the cladding film CLF. In an embodiment, for example, the portion of the cladding film CLF may be removed through a second etching process ETC2.

The second etching process ETC2 may be an entire surface etching process. Additionally, the second etching process ETC2 may be an anisotropic dry etching process. That is, the second etching process ETC2 may be an etch-back process using the anisotropic dry etching process.

Accordingly, when the second etching process ETC2 is performed on the cladding film CLF, the cladding pattern CLP located within the undercut structure UC may be formed. In other words, when performing the second etching process ETC2 on the cladding film CLF, a portion of the cladding film CLF which is obscured by the tip structure of the second sidewall pattern SW2 may not be etched and remain as the cladding pattern CLP. Accordingly, the cladding pattern CLP may be formed within the undercut structure UC of the sidewall pattern SW. That is, the cladding pattern CLP may be formed to overlap the second sidewall pattern SW2 in a plan view.

An etch rate of the capping film CPF for the second etching process ETC2 may be lower than an etch rate of the cladding film CLF for the second etching process ETC2. That is, the capping film CPF may be formed of a material with a relatively low etch rate for the second etching process ETC2, and the cladding film CLF may be formed of a material with a relatively high etch rate for the second etching process ETC2. In an embodiment, for example, the capping film CPF may not be etched by the second etching process ETC2.

Accordingly, in the second etching process ETC2, the capping film CPF may function as an etch stop layer. That is, in the second etching process ETC2, etching is stopped by the capping film CPF, so the pixel electrode PE may not be affected by the second etching process ETC2. Accordingly, the pixel electrode PE may not be damaged by the second etching process ETC2 for forming the cladding pattern CLP.

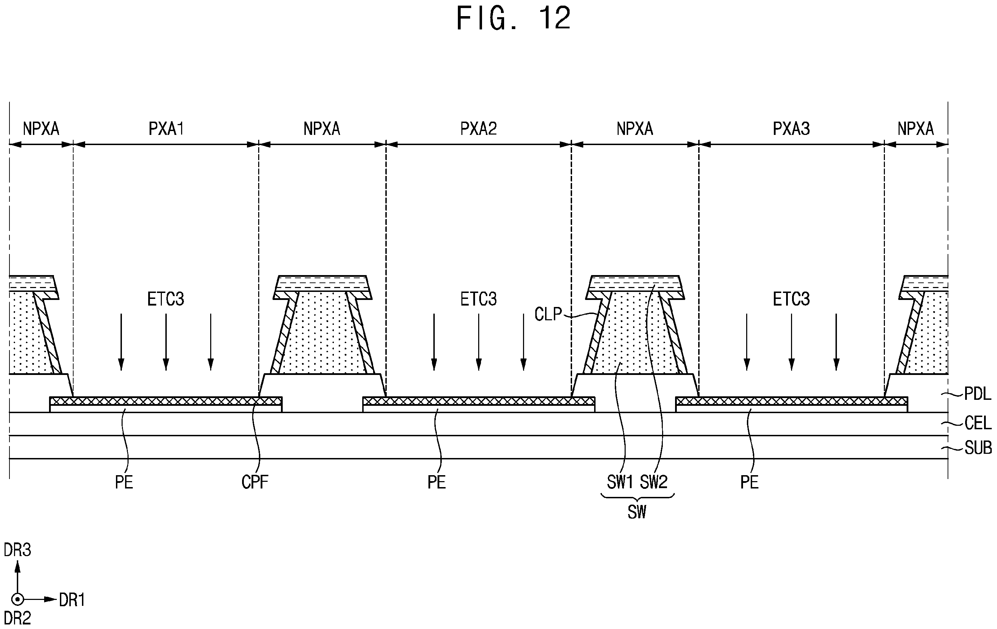

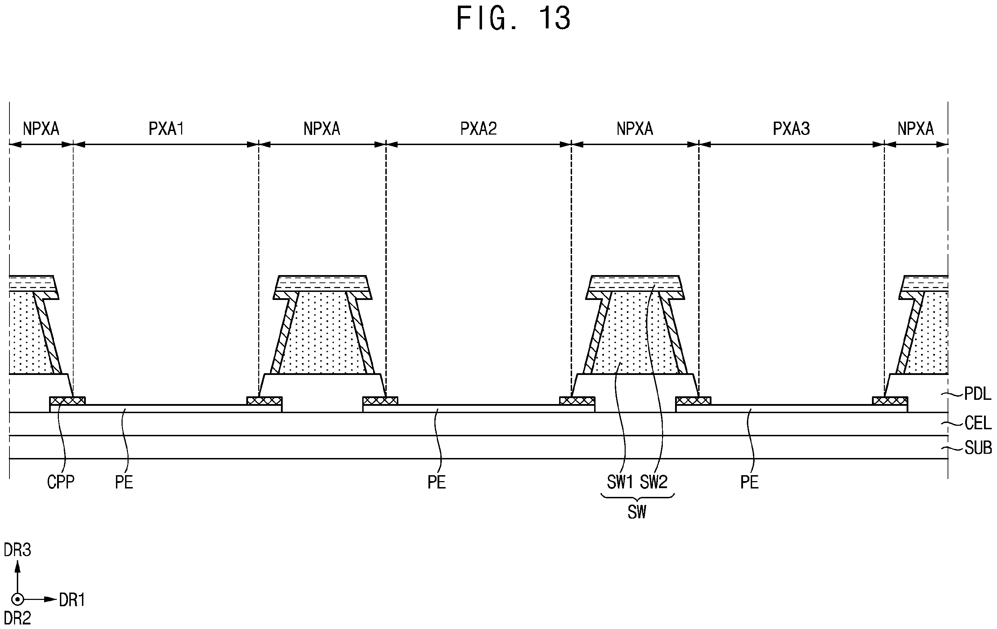

Referring to FIGS. 12 and 13, the capping pattern CPP may be formed by removing a portion of the capping film CPF. In an embodiment, for example, a portion of the capping film CPF may be removed through a third etching process ETC3. Specifically, a portion of the capping film CPF exposed from the pixel defining layer PDL may be removed through the third etching process ETC3 to form the capping pattern CPP. Accordingly, as illustrated in FIG. 13, an air gap may be defined on the pixel electrode PE due to a spacing between the capping patterns CPP. Through this air gap, leakage current between adjacent pixel areas may be further reduced. In an embodiment, the third etching process ETC3 may be a dry etching process or a wet etching process.

An etch rate of the cladding pattern CLP for the third etching process ETC3 may be lower than an etch rate of the capping film CPF for the third etching process ETC3. That is, the cladding pattern CLP may be formed of a material with a relatively low etch rate for the third etching process ETC3, and the capping film CPF may be formed of a material with a relatively high etch rate for the third etching process ETC3. In an embodiment, for example, the cladding pattern CLP may not be etched by the third etching process ETC3. Accordingly, the cladding pattern CLP may not be damaged by the third etching process ETC3 for forming the capping pattern CPP.

Additionally, an etch rate of the first sidewall pattern SW1 for the third etching process ETC3 may be lower than the etch rate of the capping film CPF for the third etching process ETC3. That is, the first sidewall pattern SW1 may be formed of a material with a relatively low etch rate for the third etching process ETC3, and the capping film CPF may be formed of a material with a relatively high etch rate for the third etching process ETC3. In an embodiment, for example, the first sidewall pattern SW1 may not be etched by the third etching process ETC3. Therefore, even if the first sidewall pattern SW1 is partially exposed from the cladding pattern CLP, the first sidewall pattern SW1 may not be damaged by the third etching process ETC3 for forming the capping pattern CPP.

Additionally, an etch rate of the second sidewall pattern SW2 for the third etching process ETC3 may be lower than the etch rate of the capping film CPF for the third etching process ETC3. That is, the second sidewall pattern SW2 may be formed of a material with a relatively low etch rate for the third etching process ETC3, and the capping film CPF may be formed of a material with a relatively high etch rate for the third etching process ETC3. In an embodiment, for example, the second sidewall pattern SW2 may not be etched by the third etching process ETC3. Accordingly, the second sidewall pattern SW2 may not be damaged by the third etching process ETC3 for forming the capping pattern CPP.

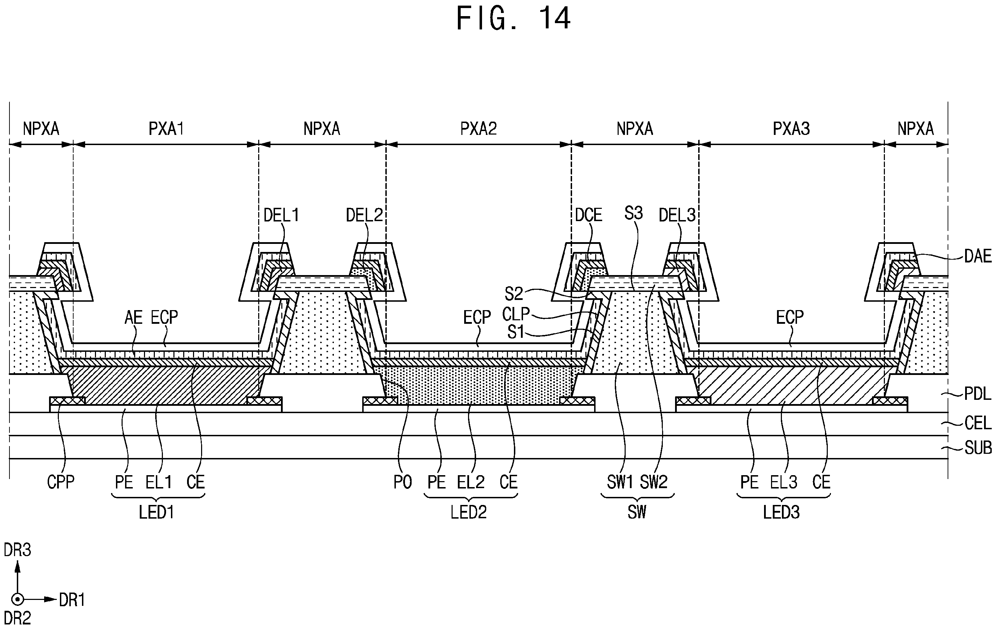

Referring to FIG. 14, the first to third light emitting layers EL1, EL2, and EL3, the first to third dummy light emitting layers DEL1, DEL2, and DEL3, the common electrode CE, the dummy common electrode DCE, the auxiliary electrode AE, the dummy auxiliary electrode DAE, and the encapsulation pattern ECP may be formed.

First, the first light emitting layer EL1 may be formed on the pixel electrode PE corresponding to the first pixel area PXA1. In this process, the first dummy light emitting layer DEL1, which is disconnected from the first light emitting layer EL1 by the undercut structure UC of the sidewall pattern SW, may be formed on the second sidewall pattern SW2 adjacent to the first pixel area PXA1. That is, the first light emitting layer EL1 and the first dummy light emitting layer DEL1 may be formed together in the same process.

Thereafter, the common electrode CE corresponding to the first pixel area PXA1 may be formed on the first light emitting layer EL1. As a result, the first light emitting element LED1 including the pixel electrode PE, the first light emitting layer EL1, and the common electrode CE may be formed in the first pixel area PXA1. In this process, the dummy common electrode DCE which is disconnected from the common electrode CE by the undercut structure UC of the sidewall pattern SW may be formed on the first dummy light emitting layer DEL1.

Thereafter, the auxiliary electrode AE corresponding to the first pixel area PXA1 may be formed on the common electrode CE corresponding to the first pixel area PXA1. In this process, the dummy auxiliary electrode DAE, which is disconnected from the auxiliary electrode AE by the undercut structure UC of the sidewall pattern SW, may be formed on the dummy common electrode DCE adjacent to the first pixel area PXA1.

Thereafter, the encapsulation pattern ECP corresponding to the first pixel area PXA1 may be formed. In an embodiment, for example, the encapsulation pattern ECP corresponding to the first pixel area PXA1 may be formed to cover the first light emitting element LED 1.

Thereafter, the second light emitting layer EL2 may be formed on the pixel electrode PE corresponding to the second pixel area PXA2. In this process, the second dummy light emitting layer DEL2, which is disconnected from the second light emitting layer EL2 by the undercut structure UC of the sidewall pattern SW, may be formed on the second sidewall pattern SW2 adjacent to the second pixel area PXA2. That is, the second light emitting layer EL2 and the second dummy light emitting layer DEL2 may be formed together in the same process.

Thereafter, the common electrode CE corresponding to the second pixel area PXA2 may be formed on the second light emitting layer EL2. As a result, the second light emitting element LED2 including the pixel electrode PE, the second light emitting layer EL2, and the common electrode CE may be formed in the second pixel area PXA2. In this process, the dummy common electrode DCE which is disconnected from the common electrode CE by the undercut structure UC of the sidewall pattern SW may be formed on the second dummy light emitting layer DEL2.

Thereafter, the auxiliary electrode AE corresponding to the second pixel area PXA2 may be formed on the common electrode CE corresponding to the second pixel area PXA2. In this process, the dummy auxiliary electrode DAE, which is disconnected from the auxiliary electrode AE by the undercut structure UC of the sidewall pattern SW, may be formed on the dummy common electrode DCE adjacent to the second pixel area PXA2.

Thereafter, the encapsulation pattern ECP corresponding to the second pixel area PXA2 may be formed. In an embodiment, for example, the encapsulation pattern ECP corresponding to the second pixel area PXA2 may be formed to cover the second light emitting element LED2.

Thereafter, the third light emitting layer EL3 may be formed on the pixel electrode PE corresponding to the third pixel area PXA3. In this process, the third dummy light emitting layer DEL3, which is disconnected from the third light emitting layer EL3 by the undercut structure UC of the sidewall pattern SW, may be formed on the second sidewall pattern SW2 adjacent to the third pixel area PXA3. That is, the third light emitting layer EL3 and the third dummy light emitting layer DEL3 may be formed together in the same process.

Thereafter, the common electrode CE corresponding to the third pixel area PXA3 may be formed on the third light emitting layer EL3. As a result, the third light emitting element LED3 including the pixel electrode PE, the third light emitting layer EL3, and the common electrode CE may be formed in the third pixel area PXA3. In this process, the dummy common electrode DCE which is disconnected from the common electrode CE by the undercut structure UC of the sidewall pattern SW may be formed on the third dummy light emitting layer DEL3.

Thereafter, the auxiliary electrode AE corresponding to the third pixel area PXA3 may be formed on the common electrode CE corresponding to the third pixel area PXA3. In this process, the dummy auxiliary electrode DAE, which is disconnected from the auxiliary electrode AE by the undercut structure UC of the sidewall pattern SW, may be formed on the dummy common electrode DCE adjacent to the third pixel area PXA3.

Thereafter, the encapsulation pattern ECP corresponding to the third pixel area PXA3 may be formed. In an embodiment, for example, the encapsulation pattern ECP corresponding to the third pixel area PXA3 may be formed to cover the third light emitting element LED3.

In an embodiment, the first to third light emitting layers EL1, EL2, and EL3 and the first to third dummy light emitting layers DEL1, DEL2, and DEL3 may be formed through a process of depositing an organic material. In an embodiment, for example, the organic material may include an organic light emitting material. However, the present invention is not necessarily limited thereto.

Additionally, the common electrode CE and the dummy common electrode DCE may be formed through a process of depositing a conductive material. In an embodiment, for example, the conductive material may include metal, alloy, metal oxide, transparent conductive material, or the like.

Additionally, the auxiliary electrode AE and the dummy auxiliary electrode DAE may be formed of a transparent conductive oxide. The transparent conductive oxide may include indium zinc oxide (IZO), indium tin oxide (ITO), or the like.

Additionally, in an embodiment, the encapsulation pattern ECP may be formed of an inorganic material.

After forming the encapsulation pattern ECP, as illustrated in FIG. 2, the first encapsulation layer ECL1 and the second encapsulation layer ECL2 may be formed. As a result, the encapsulation member including the encapsulation pattern ECP, the first encapsulation layer ECL1, and the second encapsulation layer ECL2 may be formed. In an embodiment, the first encapsulation layer ECL1 may be formed of an organic material, and the second encapsulation layer ECL2 may be formed of an inorganic material.

In the method of manufacturing the display device DD according to embodiments of the present invention, the cladding pattern CLP may be formed through an etching process (e.g., the second etching process ETC2 of FIG. 10) on the cladding film CLF using the undercut structure UC of the sidewall pattern SW. In an embodiment, for example, the cladding pattern CLP may be formed by etching the cladding film CLF by an etch-back process using an anisotropic dry etching process. Accordingly, the cladding pattern CLP may be formed without a separate mask or photoresist pattern. Accordingly, the display device DD may be easily formed, and an efficiency of manufacturing process of the display device DD may be effectively improved.

Additionally, in the method of manufacturing the display device DD according to embodiments of the present invention, the etch rate of the capping film CPF for the etching process may be lower than an etch rate of the cladding film CLF for the etching process. Accordingly, in the etching process to form the cladding pattern CLP, the capping film CPF may function as an etch stop layer. Accordingly, the pixel electrode PE under the capping film CPF may not be damaged by the etching process to form the cladding pattern CLP. Accordingly, the reliability of the display device DD may not deteriorate.

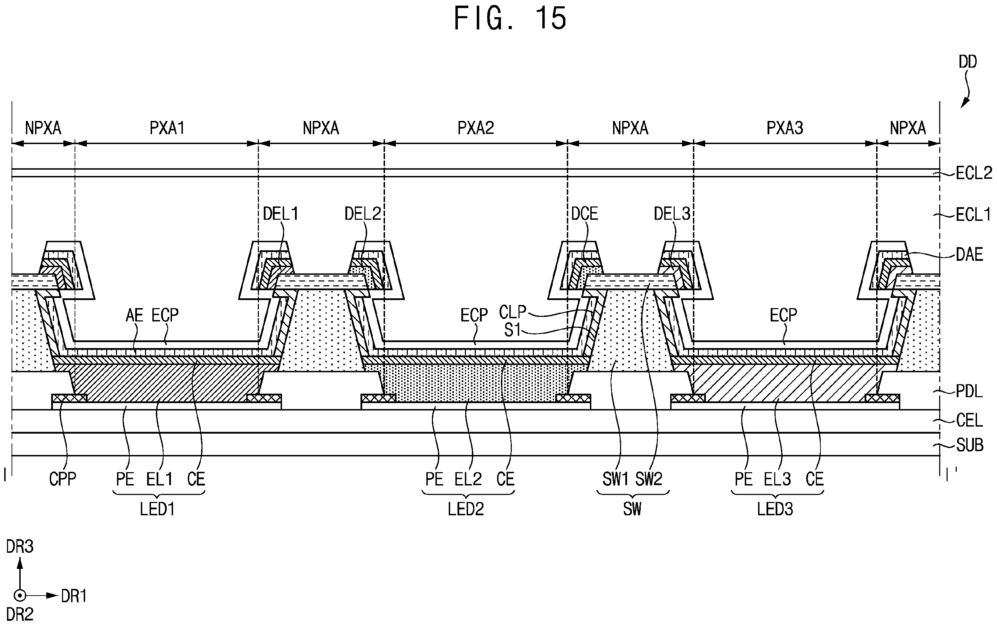

FIG. 15 is a cross-sectional view illustrating another example taken along line I-I' of FIG. 1.

An example of the display device DD described with reference to FIG. 15 may be substantially same as the example of the display device DD described with reference to FIG. 2 except that the cladding pattern CLP covers just a part of the side surface of the first sidewall pattern SW1. Therefore, overlapping descriptions will be omitted.

Referring to FIG. 15, as described above, in an embodiment, the cladding pattern CLP may cover just a part of the side surface S1 of the first sidewall pattern SW1. In an embodiment, for example, by adjusting a length of the tip structure of the second sidewall pattern SW2 in the first direction DR1, a coverage area of the cladding pattern CLP formed through the second etching process ETC2 (see FIG. 10) to the side surface S1 of the first sidewall pattern SW1 may be variously changed.

In this case, as illustrated in FIG. 15, the common electrode CE may directly contact the first sidewall pattern SW1. However, the present invention is not necessarily limited thereto. For another example, even when the cladding pattern CLP covers just a part of the side surface S1 of the first sidewall pattern SW1, the common electrode CE may not directly contact the side surface S1 of the first sidewall pattern SW1, but may be electrically connected to the first sidewall pattern SW1 through the cladding pattern CLP.

A method of manufacturing the display device DD of FIG. 15 may be substantially same as the method of manufacturing the display device DD described with reference to FIGS. 4 to 14 except for forming the cladding pattern CLP which covers just a part of the side surface S1 of the sidewall pattern SW1 by adjusting a process condition of the first etching process (ETC1, see FIG. 7) and/or the second etching process (ETC2, see FIG. 10). Therefore, detailed description will be omitted.

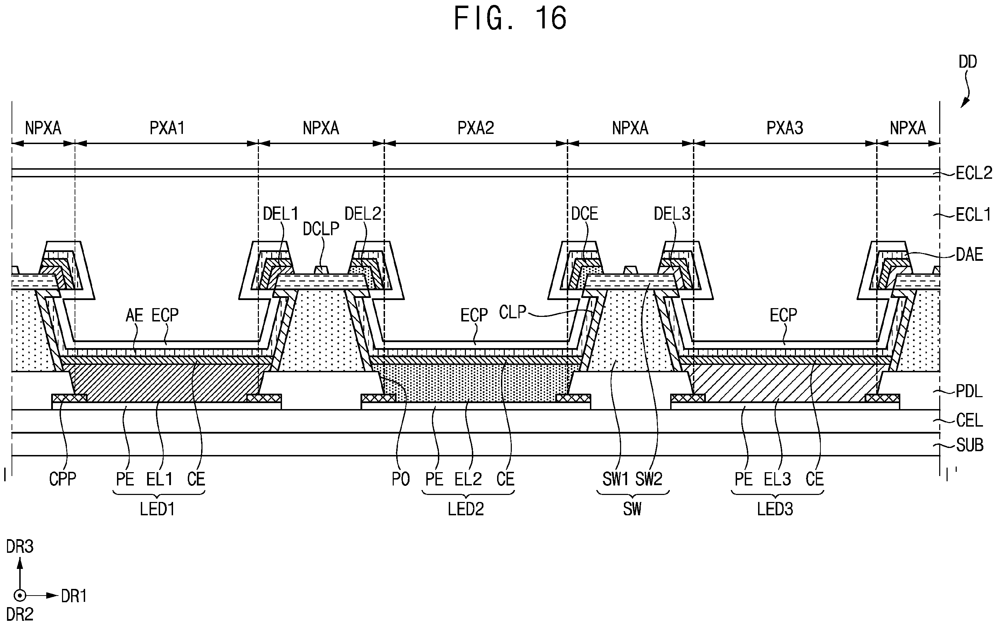

FIG. 16 is a cross-sectional view illustrating still another example taken along line I-I' of FIG. 1.

An example of the display device DD described with reference to FIG. 16 may be substantially same as the example of the display device DD described with reference to FIG. 2 except for further including a dummy cladding pattern DCLP. Therefore, overlapping descriptions will be omitted.

Referring to FIG. 16, in an embodiment, the display device DD may further include the dummy cladding pattern DCLP. The dummy cladding pattern DCLP may be disposed on the second sidewall pattern SW2. In an embodiment, for example, the dummy cladding pattern DCLP may contact an upper surface of the second sidewall pattern SW2.

The dummy cladding pattern DCLP may include the same material as the cladding pattern CLP. That is, the dummy cladding pattern DCLP may include a conductive material. In an embodiment, for example, the dummy cladding pattern DCLP may include molybdenum (Mo).

The dummy cladding pattern DCLP may be formed as a portion of the cladding film CLF remains on the second sidewall pattern SW2 after the second etching process (ETC2, see FIG. 10). That is, the dummy cladding pattern DCLP may be a residue of the cladding film CLF that has not been removed on the second sidewall pattern SW2 even after the second etching process ETC2 to form the cladding pattern CLP. That is, the dummy cladding pattern DCLP may be formed in the same process as the cladding pattern CLP.

When the display device DD further includes the dummy cladding pattern DCLP, a position of the dummy cladding pattern DCLP is not limited to positions illustrated in FIG. 16. For another example, the position of the dummy cladding pattern DCLP may be changed in various ways on the second sidewall pattern SW2.

The present disclosure can be applied to a display panel inspection device of various display devices. For example, the present disclosure is applicable to a display panel inspection device of various display devices such as display devices for vehicles, ships and aircraft, portable communication devices, display devices for exhibition or information transmission, medical display devices, and the like.

The foregoing is illustrative of embodiments and is not to be construed as limiting thereof. Although a few embodiments have been described, those skilled in the art will readily appreciate that many modifications are possible in the embodiments without materially departing from the novel teachings and advantages of the present invention. Accordingly, all such modifications are intended to be included within the scope of the present invention as defined in the claims. Therefore, it is to be understood that the foregoing is illustrative of various embodiments and is not to be construed as limited to the specific embodiments disclosed, and that modifications to the disclosed embodiments, as well as other embodiments, are intended to be included within the scope of the appended claims.

## Claims

1. A display device comprising:
a pixel electrode on a substrate;
a pixel defining layer on the substrate and the pixel electrode and defining a pixel opening exposing at least a portion of the pixel electrode;
a first sidewall pattern on the pixel defining layer and including a conductive material;
a second sidewall pattern on the first sidewall pattern and having a lower surface defining an undercut structure together with a side surface of the first sidewall pattern in a cross-sectional view;
a cladding pattern, which covers at least a portion of the side surface of the first sidewall pattern and includes a conductive material;
a light emitting layer on the pixel electrode in the pixel opening; and
a common electrode on the light emitting layer and electrically connected to the cladding pattern.

2. The display device of claim 1, wherein the cladding pattern contacts the side surface of the first sidewall pattern and the lower surface of the second sidewall pattern.

3. The display device of claim 1 or claim 2, wherein the cladding pattern covers an entirety of a portion, of the lower surface of the second sidewall pattern, that protrudes from an upper surface of the first sidewall pattern.

4. The display device of any one of claims 1 to 3, wherein:
(i) the cladding pattern continuously extends from the side surface of the first sidewall pattern to the lower surface of the second sidewall pattern; and/or
(ii) the cladding pattern is located within the undercut structure.

5. The display device of any one of claims 1 to 4, wherein:
(i) the cladding pattern overlaps the second sidewall pattern in a plan view; and/or
(ii) the cladding pattern and the first sidewall pattern include different materials from each other; and/or
(iii) the cladding pattern includes molybdenum (Mo).

6. The display device of any one of claims 1 to 5, further comprising:
an auxiliary electrode on the common electrode and in contact with the cladding pattern.

7. The display device of claim 6, wherein:
(i) a contact area between the cladding pattern and the auxiliary electrode is larger than a contact area between the cladding pattern and the common electrode; and/or
(ii) the auxiliary electrode includes a conductive oxide.

8. The display device of any one of claims 1 to 7, further comprising:
(i) a capping pattern on the pixel electrode, at least partially covered by the pixel defining layer, and including a material different from the cladding pattern, optionally wherein the capping pattern includes a conductive oxide; and/or
(ii) a dummy cladding pattern which contacts an upper surface of the second sidewall pattern and includes a same material as the cladding pattern.

9. The display device of any one of claims 1 to 8, wherein:
(i) the cladding pattern covers an entirety of the side surface of the first sidewall pattern; or
(ii) the cladding pattern covers a part of the side surface of the first sidewall pattern, not an entirety of the side surface.

10. The display device of any one of claims 1 to 9, further comprising:
a dummy light emitting layer, which is disconnected from the light emitting layer, includes a same material as the light emitting layer, and is disposed on the second sidewall pattern; and
a dummy common electrode, which is disconnected from the common electrode, includes a same material as the common electrode, and is disposed on the dummy light emitting layer.

11. A method of manufacturing a display device, the method comprising:
forming a pixel electrode on a substrate;
forming a capping film on the pixel electrode;
forming a pixel defining layer on the substrate to cover at least a portion of the pixel electrode and at least a portion of the capping film;
forming a first sidewall pattern including a conductive material on the pixel defining layer, and forming a second sidewall pattern including a material different from the first sidewall pattern on the first sidewall pattern;
removing a portion of the first sidewall pattern to form an undercut structure defined by a side surface of the first sidewall pattern and a lower surface of the second sidewall pattern in a cross-sectional view;
forming a cladding film including a conductive material on the capping film, the pixel defining layer, the first sidewall pattern, and the second sidewall pattern;
forming a cladding pattern covering at least a portion of the side surface of the first sidewall pattern by removing a portion of the cladding film through a first etching process; and
forming a capping pattern by removing a portion of the capping film through a second etching process.

12. The method of claim 11, wherein an etch rate of the capping film for the first etching process is lower than an etch rate of the cladding film for the first etch process.

13. The method of claim 11 or claim 12, wherein an etch rate of each of the first sidewall pattern, the second sidewall pattern, and the cladding pattern for the second etching process is lower than an etch rate of the capping film for the second etch process.

14. The method of any one of claims 11 to 13, wherein:
(i) the first etching process is an entire surface etching process; and/or
(ii) the first etching process is an anisotropic dry etching process.

15. The method of any one of claims 11 to 14, wherein:
(i) in the forming the cladding pattern, the cladding film is etched such that the cladding pattern is located within the undercut structure; and/or
(ii) in the forming of the cladding pattern, the cladding film is etched such that that the cladding pattern overlaps the second sidewall pattern in a plan view; and/or
(iii) the cladding film is formed to cover an entirety of the first sidewall pattern and the second sidewall pattern.
